# EUROPEAN PATENT APPLICATION

(11) **EP 4 328 002 A1**
(43) Date of publication of application: **28.02.2024**
(21) Application number: 23189716.6
(22) Date of filing: 04.08.2023
(51) Int. Cl.: B29C 45/14, G02F 1/13, B29L 31/34

(54) **DISPLAY DEVICE CABINET AND METHOD OF MANUFACTURING DISPLAY DEVICE CABINET**

(30) Priority: 26.08.2022 JP 2022135032
(71) Applicant: Alps Alpine Co., Ltd., Ota-ku, Tokyo 145-8501 (JP)
(72) Inventor: Saeki, Takuya, Iwaki, Fukushima (JP)
(74) Representative: Schmitt-Nilson Schraud Waibel Wohlfrom Patentanwälte Partnerschaft mbB

(57) **Abstract**

A frame and a surface panel having a panel body, which is a glass plate, are integrated together by a so-called insert molding method. The frame is formed from an elastomer. An inner-surface tight-contact surface formed as part of an inner surface support portion of the frame has a tight-contact edge portion positioned on the same side as the center of the surface panel. The tight-contact edge portion is formed at a position at which the tight-contact edge portion overlaps both a decorative layer and an adhesion functional resin layer. As a result, it is possible to restrain stress from being exerted directly on the decorative layer from the tight-contact edge portion.

## Description

The present invention relates to a display device cabinet formed by integrating a transparent surface panel and a frame made of a synthetic resin together by a so-called insert molding method and to a method of manufacturing the display device cabinet.

An integrally molded glass product is illustrated in Fig. 14 in JP 2013-139136 A. With this integrally molded glass product, a decorative layer is formed on the lower surface of the circumferential area of a glass plate. An adhesive layer is formed so as to be overlaid on the decorative layer. In a method of manufacturing the integrally molded glass product, as illustrated in Fig. 15 and other drawings, the inner surface of the glass plate is sucked to one mold; the glass plate is fixed in two clamped molds; a melted resin is injected into a cavity formed in the molds; and the melted resin is cured to form a frame body. The decorative layer can be visually recognized through the outer surface of the glass plate, so the decorative function is fully used.

with this type of integrally molded glass product, a width W3 of the decorative layer is wider than a width W4 of the adhesive layer, and the width W4 of the adhesive layer is narrower than the upper surface of the edge portion of the frame body, the edge portion supporting the glass plate, as described in paragraph [0049] in JP 2013-139136 A. As a result, the edge portion of the frame body extends to the side surface of the adhesive layer and turns along the side surface. Therefore, the edge portion of the frame body covers the adhesive layer and is contact with the lower surface of the decorative layer.

with an integrally molded glass product, there is a difference in coefficient of linear expansion between a glass substrate and a resin material forming a frame body. When a large change in temperature occurs in the usage environment, therefore, thermal stress is exerted on a portion in tight contact between the frame body and the glass substrate. In the structure illustrated in Fig. 14 in JP 2013-139136 A, part of the edge portion of the frame body is in direct contact with the decorative layer formed on the inner surface of the glass substrate. Therefore, thermal stress is likely to concentrate on the decorative layer at the contact portion between the decorative layer and the edge portion of the frame body. This may cause a crack in a portion of the decorative layer, the portion being in contact with the edge portion. Another possible problem is that another portion of the decorative layer, the portion extending beyond the edge portion of the frame body, is separated from the glass plate.

In a process in which an integrally molded glass product is formed by insert molding, a glass plate is interposed between two molds. In the structure illustrated in Fig. 14, part of the decorative layer is directly pressurized by a mold, so the decorative layer is likely to be damaged during mold clamping.

An object of the present invention is to provide a display device cabinet that makes a decorative layer formed on a panel body less likely to be damaged during mold clamping and also makes the decorative layer less likely to be cracked or separated due to thermal stress after the display device cabinet is completed, and also provide a method of manufacturing such a display device cabinet.

The invention relates to a display device cabinet and a method of manufacturing a display device cabinet according to the appended claims. Embodiments are disclosed in the dependent claims.

A display device cabinet according to an aspect of the present invention has a frame having an opening for display use and also has a surface panel fixed to the opening. The surface panel has a panel body formed from a transparent material, a decorative layer, which is colored, in tight contact with the inner surface of the circumferential area of the panel body, the inner surface facing the interior of the display device cabinet, and an adhesion functional resin layer overlaid on the inner surface of the decorative layer. The frame is formed from a synthetic resin material cured while in a tight contact with the surface panel. The frame has an end-face tight contact surface in tight contact with an end face of the surface panel and also has an inner-surface tight-contact surface in tight contact with the inner surface of the circumferential area of the panel body. A tight-contact edge portion facing the center of the surface panel is formed as part of the inner-surface tight-contact surface so that the tight-contact edge portion is at a position at which the tight-contact edge portion overlaps both the decorative layer and the adhesion functional resin layer.

With the display device cabinet according to aspects of the present invention, a resin edge portion of the adhesion functional resin layer, the resin edge portion facing the center of the surface panel, is at the same position as a decorative edge portion of the decorative layer, the decorative edge portion facing the center of the surface panel, or at a position closer to the end face than the decorative edge portion is; and the tight-contact edge portion is at the same position as the resin edge portion or at a position closer to the end face than the resin edge portion is.

With the display device cabinet according to the present invention, an inner surface support portion facing the interior of the display device cabinet is preferably formed as part of the frame. The inner surface support portion preferably has the inner-surface tight-contact surface and an inner end face facing the center of the surface panel. An inner end edge portion of the inner end face, the inner end edge portion facing the interior of the display device cabinet, is preferably at a position closer to the end face than the tight-contact edge portion is.

For example, a concave surface contiguous to the tight-contact edge portion is preferably formed as part of the inner end face.

With the display device cabinet according to the present invention, the frame is preferably formed from an elastomer having a tensile elastic modulus of at least 100 MPa and at most 500 MPa.

With the display device cabinet according to the present invention, the frame is preferably formed from an elastomer having a bending elastic modulus of at least 200 MPa and at most 1000 MPa.

In this case, a rear cover is linked to the frame to form the display device cabinet. The rear cover has a larger tensile elastic modulus and a larger bending elastic modulus than the frame. The rear cover has a larger surface area than the frame.

In a method, according to an aspect of the present invention, of manufacturing a display device cabinet that has a frame having an opening for display use and also has a surface panel fixed to the opening, the method includes: using a surface panel that has a panel body formed from a transparent material, a decorative layer, which is colored, in tight contact with the inner surface of a circumferential area of the panel body, the inner surface facing the interior of the display device cabinet, and an adhesion functional resin layer overlaid on the inner surface of the decorative layer; molding the frame from a synthetic resin material with the surface panel fixed in molds so that the frame has an end-face tight contact surface in tight contact with an end face of the surface panel and also has an inner-surface tight-contact surface in tight contact with the inner surface of the circumferential area of the panel body; and forming a tight-contact edge portion, which faces the center of the surface panel, as part of the inner-surface tight-contact surface so that the tight-contact edge portion is at a position at which the tight-contact edge portion overlaps both the decorative layer and the adhesion functional resin layer.

In the method, according to an embodiment of the present invention, of manufacturing a display device cabinet, the method further includes forming a resin edge portion, which faces the center of the surface panel, as part of the adhesion functional resin layer so that the resin edge portion is at the same position as a decorative edge portion of the decorative layer, the decorative edge portion facing the center of the surface panel, or at a position closer to the end face than the decorative edge portion is. The tight-contact edge portion is formed at the same position as the resin edge portion or at a position closer to the end face than the resin edge portion is.

In the method, according to an embodiment of the present invention, of manufacturing a display device cabinet, the method preferably further includes forming an inner surface support portion, which faces the interior of the display device cabinet, as part of the frame, the inner surface support portion having the inner-surface tight-contact surface and an inner end face facing the center of the surface panel; and forming an inner end edge portion, which faces the interior of the display device cabinet, as part of the inner end face so that the inner end is at a position closer to the end face than the tight-contact edge portion is.

For example, a concave surface contiguous to the tight-contact edge portion is preferably formed as part of the inner end face.

With the display device cabinet according to aspects of the present invention, a tight-contact edge portion, oriented to the center of a surface panel, of an inner-surface tight-contact surface, which is part of a frame, is formed at a position at which the tight-contact edge portion overlaps both a decorative layer formed on the inner surface of a panel body and an adhesion functional resin layer. Therefore, even when thermal stress is exerted due to a difference in coefficient of linear expansion between the panel body and the frame, the adhesion functional resin layer functions as a cushion layer, suppressing direct damage to the decorative layer.

In the method, according to aspects of the present invention, of manufacturing the display device cabinet, the edge portion of a mold that holds the inner surface of the surface panel abuts the adhesion functional resin layer when the surface panel is interposed in molds. Therefore, the edge portion of the mold does not come into direct contact with the decorative layer. This can prevent the decorative layer from being directly damaged due to a pressurizing force concentrated on the edge portion of the mold.
Fig. 1 is a half sectional view illustrating a vehicle-mounted display device as an example of a display device including a display device cabinet according to an embodiment of the present invention;
Fig. 2 is a partially enlarged view illustrating an embodiment of the display device cabinet of the present invention;
Fig. 3 is a partially enlarged view illustrating an embodiment of a method of manufacturing a display device cabinet according to an embodiment of the present invention; and
Figs. 4A and 4B are partially enlarged views illustrating variations of the display device cabinet.

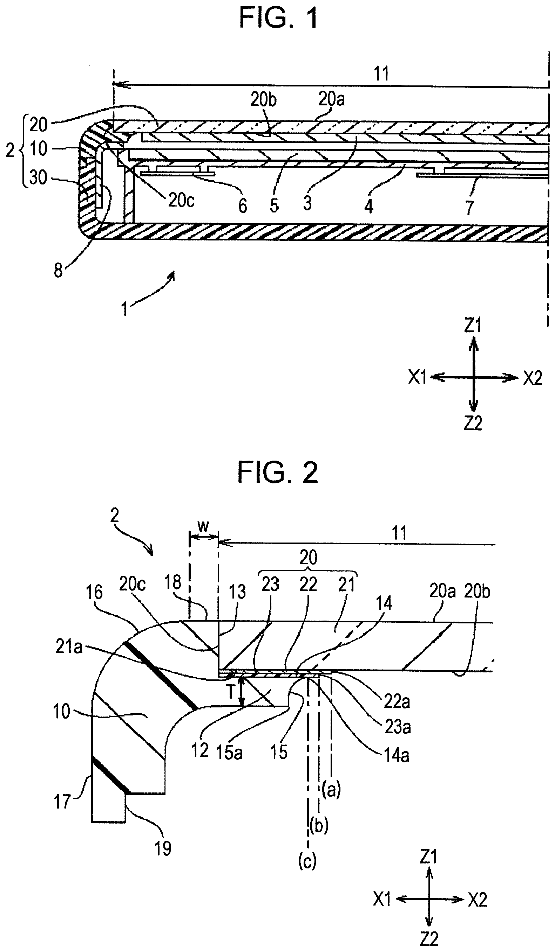

Fig. 1 is a half sectional view illustrating a vehicle-mounted display device 1 as an example of a display device including a display device cabinet 2 according to an embodiment of the present invention. The forward direction of the vehicle-mounted display 1 is the Z1 direction, and the backward direction is the Z2 direction. A display is directed in the room of the vehicle in the Z1 direction. The X1-X2 direction is the traverse direction; the X1 direction is the left direction and the X2 direction is the right direction. The front of the vehicle-mounted display 1 is in a rectangular shape when the backward side (the Z2-direction side) of the vehicle-mounted display 1 is viewed from a position on the forward side (Z1-direction side). The X1-X2 direction is the long-edge direction. In Fig. 1 and later drawings, only the left side of the vehicle-mounted display 1 when viewed toward the drawing sheet is illustrated as the half sectional view. Therefore, the X1 direction is toward the end face of a surface panel on the left side, the X2 direction is toward the center of the surface panel. The Z2 direction is toward the interior of the display device cabinet 2.

The vehicle-mounted display 1 in Fig. 1 has the display device cabinet 2. The display device cabinet 2 has a frame 10, a surface panel 20 fixed to an opening 11 formed in the frame 10, and a rear cover 30 linked to the back of the frame 10. The front of the frame 10 is in a rectangular shape when viewed from the forward side. The opening 11 is also rectangular. Therefore, the surface panel 20 fixed in this opening 11 is also rectangular. The inner surfaces of the frame 10 and surface panel 20 are oriented in the Z2 direction, and their outer surfaces are oriented in the Z1 direction. In the display device cabinet 2, a display cell 3 is bonded to an inner surface 20b of the surface panel 20 with an optical adhesive. A sheet-like sensor is attached between the display cell 3 and the inner surface 20b of the surface panel 20 or to an outer surface 20a of the surface panel 20. The touch sensor is a capacitance detection sensor that senses a proximity or contact of a finger of a human body. A support base 4 made of a synthetic resin or light metal is fixed in the display device cabinet 2. The display cell 3 is a color liquid crystal display cell. A backlight unit 5 is fixed to the support base 4. The display cell 3 may be an organic electroluminescent (EL) cell or the like. Circuit boards 6 and 7 are also fixed to the support base 4. A reinforcing member 8 is provided in the display device cabinet 2. The reinforcing member 8 reinforces a portion at which the frame 10 and rear cover 30 are bonded together from the inside.

Fig. 2 is an enlarged view of part of the display device cabinet 2 on the X1 side. The frame 10 of the display device cabinet 2 is molded from a synthetic resin material. Upon the molding of the frame 10, the synthetic resin has been changed to an elastomer having a relatively low tensile elastic modulus (longitudinal elastic modulus) and a relatively low bending elastic modulus. The surface panel 20 is transparent. The frame 10 and surface panel 20 are integrally molded together by a so-called insert molding method. The rear cover 30 is formed from a hard synthetic resin material that has a higher longitudinal elastic modulus and a higher bending elastic modulus and is more rigid when compared with the frame 10. Alternatively, the rear cover 30 is die-cast by using a light metal material. The frame 10 and rear cover 30 are fitted to each other and are fixed with an adhesive or fixed by being screwed.

The frame 10 is formed from an elastomer having a tensile elastic modulus (longitudinal elastic modulus) of at least 100 MPa and at most 500 MPa and having a tensile break strength of at least 5 MPa and at most 40 MPa. The bending elastic modulus of the elastomer of frame 10 is preferably at least 200 MPa and at most 1000 MPa, and is more preferably at least 200 MPa and at most 500 MPa. The synthetic resin material of the frame 10 is, for example, a thermoplastic polyester elastomer (its product name is Hytrel) from Du Pont. This elastomer is a copolymer of butylene phthalate and poly (alkylene ether) phthalate. The elastomer has a tensile elastic modulus (longitudinal elastic modulus) of at least 150 MPa and at most 310 MPa and a tensile break strength of at least 10 MPa and at most 35 MPa when measured according to JIS K 7113 (1995).

General synthetic resin materials from which the cabinets of electronic devices are molded will be described as comparative examples. An acrylonitrile-butadiene-styrene (ABS) resin material has a tensile elastic modulus of about 3000 MPa and a bending elastic modulus of about 3000 MPa. A polymethyl methacrylate (PMMA) resin material has a tensile elastic modulus of about 3300 MPa and a bending elastic modulus of about 3300 MPa. A polyoxymethylene (POM) resin material has a tensile elastic modulus of about 2300 MPa and a bending elastic modulus of about 2200 MPa. The frame 10 in the embodiment of the present invention has an extremely flexible structure that can be elastically deformed unlike these comparative examples.

The surface panel 20 has a panel body 21, which is a transparent glass plate, a decorative layer 22 in tight contact with an inner surface 21a of the circumferential area of the panel body 21, an adhesion functional resin layer 23 in tight contact with the inner surface of the decorative layer 22, as illustrated in Fig. 2. The decorative layer 22 is formed on the inner surface 21a of the circumferential area of the panel body 21 by screen-printing with a non-translucent screen ink colored in, for example, black. The adhesion functional resin layer 23 is formed on the inner surface of the decorative layer 22 by screen-printing with a screen ink. In a manufacturing process in an insert molding method, when the adhesion functional resin layer 23 comes into contact with a melted resin, which will form the frame 10, the adhesion functional resin layer 23 melts due to the heat of the melted resin and functions a fusible binder. When the melted resin is cured, the frame 10 and surface panel 20 are fastened together with the adhesion functional resin layer 23 interposed between them.

At the edge portion of the opening 11 formed in the frame 10, an inner surface support portion 12 is integrally formed as part of the frame 10 so as to extend toward the center of the surface panel 20. The outer surface of the inner surface support portion 12 is an inner-surface tight-contact surface 14, which is in tight contact with the inner surface 20b of the surface panel 20, that is, the inner surface of the adhesion functional resin layer 23. The edge portion of the opening 11 in the frame 10 is an end-face tight contact surface 13, which is in tight contact with four end faces 20c of the surface panel 20.

In Fig. 2, the position of a decorative edge portion 22a of the decorative layer 22 in the traverse direction (X1-X2 direction) is indicated by (a), the decorative edge portion 22a being oriented to the center of the surface panel 20 (in the X2 direction); the position of a resin edge portion 23a of the adhesion functional resin layer 23 in the traverse direction is indicated by (b), the resin edge portion 23a being oriented to the center of the surface panel 20; and the position of a tight-contact edge portion 14a of the inner-surface tight-contact surface 14 is indicated by (c), the tight-contact edge portion 14a being oriented to the center of the surface panel 20. The resin edge portion 23a is at the same position as the decorative edge portion 22a in the traverse direction or is preferably at a position closer to the end face 20c of the surface panel 20 than the decorative edge portion 22a is, as illustrated in Fig. 2. The tight-contact edge portion 14a is at the same position as the resin edge portion 23a in the traverse direction or is preferably at a position closer to the end face 20c of the surface panel 20 than the resin edge portion 23a is, as illustrated in Fig. 2. That is, the tight-contact edge portion 14a of the inner-surface tight-contact surface 14 is at a position at which the tight-contact edge portion 14a overlaps both the decorative layer 22 and the adhesion functional resin layer 23.

An inner end face 15 of the inner surface support portion 12 formed as part of the frame 10, the inner end face 15 facing the center of the surface panel 20 (in the X2 direction), is a concave surface. That is, the cross-sectional shape of the inner end face 15 is represented as a concave curved line that is recessed toward the end face 20c of the surface panel 20 (in the X1 direction). As a result, an inner end edge portion 15a of the inner end face 15, the inner end edge portion 15a facing the interior of the display device cabinet 2 (in the Z2 direction), is at a position at which the inner end edge portion 15a is further closer to the end face 20c of the surface panel 20 than the tight-contact edge portion 14a is.

A frame flat surface 18, a side surface 17, and a convex curved surface 16 are formed on the outer surface of the frame 10, as illustrated in Fig. 2. The frame flat surface 18 is flush with the outer surface 20a of the surface panel 20 and is contiguous to the outer surface 20a. The side surface 17 extends in the front-back direction (Z1-Z2 direction). The convex curved surface 16 links the frame flat surface 18 and side surface 17 together. The frame flat surface 18 is formed so as to have a predetermined width W in the traverse direction (X1-X2 direction). The end of the frame 10 in the backward direction (Z2 direction) is a linking portion 19 to the rear cover 30.

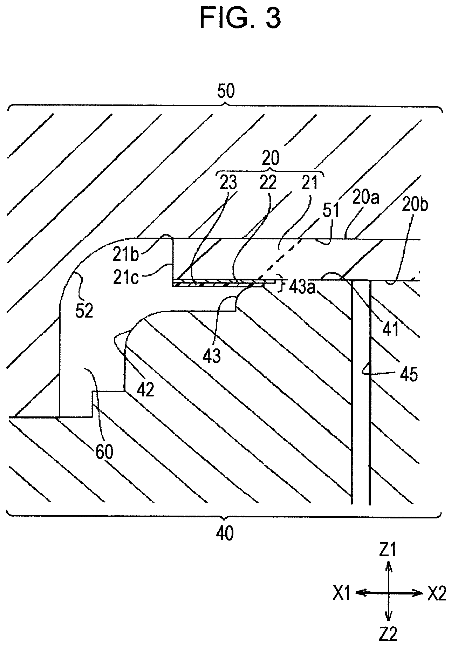

Fig. 3 illustrates an embodiment of a manufacturing process (manufacturing method) for integrally molding the frame 10 and surface panel 20 together by a so-called insert molding method. In the insert molding method, a first mold 40 and a second mold 50 are used. The first mold 40 has an interposing flat surface 41, on which the inner surface 20b of the surface panel 20 is held. A suction hole 45 communicating with the interposing flat surface 41 is formed in the first mold 40. The first mold 40 also has an inner surface molding surface 42, on which the inner surface of the frame 10 is molded. The inner surface molding surface 42 has a convex curved surface 43, on which the inner end face 15 of the inner surface support portion 12 of the frame 10 is molded, on the Z1 side. Fig. 3 is drawn as if a step 43a, the width of which is equivalent to the total thickness of the decorative layer 22 and adhesion functional resin layer 23, were formed on the boundary between the interposing flat surface 41 and the convex curved surface 43. In practice, however, the total thickness dimension of the decorative layer 22 and adhesion functional resin layer 23 is minute when compared with the thickness dimension of the glass plate forming the panel body 21. Therefore, the first mold 40 lacks the step 43a. The convex curved surface 43 and the interposing flat surface 41, which is a flat surface, are smoothly contiguous to each other.

The second mold 50 has an interposing flat surface 51, on which the outer surface 20a of the surface panel 20 is held, and also has an outer surface molding surface 52, on which the outer surface of the frame 10 is molded. The first mold 40 and second mold 50 are clamped together in a state in which the panel body 21 is held to the interposing flat surface 41 by withdrawing air through the suction hole 45, as illustrated in Fig. 3. In the clamped state, the surface panel 20 is interposed between the first mold 40 and the second mold 50 and is fixed in them. In addition, a cavity 60 is formed, which is enclosed by the inner surface molding surface 42 of the first mold 40, the outer surface molding surface 52 of the second mold 50, the end face 20c of the surface panel 20, and part of the inner surface 20b.

In the state in which the first mold 40 and second mold 50 are clamped together, a melted resin, which will become an elastomer, is injected from a sprue into the cavity 60, after which the resin is cooled and cured to form the frame 10. In a state in which the frame 10 has been removed from the first mold 40 and second mold 50, the end-face tight contact surface 13 of the frame 10 is in tight contact with the end face 20c of the surface panel 20 and the inner-surface tight-contact surface 14 of the frame 10 is in tight contact with the circumferential area of the inner surface 20b of the surface panel 20.

With the display device cabinet 2, there is a difference in coefficient of linear expansion between a synthetic resin material forming the frame 10 and a glass plate forming the panel body 21. When a large change in temperature occurs in the usage environment of the vehicle-mounted display device 1, therefore, thermal stress is exerted on the bonded portion between the frame 10 and the panel body 21. As illustrated in Fig. 2, however, the tight-contact surface 14 of the frame 10 has the tight-contact edge portion 14a, which faces the center of the surface panel 20, at a position at which the tight-contact edge portion 14a overlaps both the decorative layer 22 and the adhesion functional resin layer 23; substantially the whole of the inner-surface tight-contact surface 14 is in tight contact with the adhesion functional resin layer 23; and the inner-surface tight-contact surface 14 and decorative layer 22 are not in direct contact with each other. Therefore, even when the thermal stress is exerted, the adhesion functional resin layer 23 functions as a cushion layer and can mitigate the thermal stress exerted on the decorative layer 22. If the tight-contact edge portion 14a is in direct contact with the decorative layer 22, the problem may occur that thermal stress causes a crack or the like in the decorative layer 22 at a portion at which the decorative layer 22 is in contact with the tight-contact edge portion 14a and part of the decorative layer 22 is thereby separated from the panel body 21. With the display device cabinet 2, however, the adhesion functional resin layer 23 is fully used as the cushion function and functions as the cushion layer, so it is easy to prevent the decorative layer 22 from being damaged.

The inner end edge portion 15a of the inner end face 15 of the inner surface support portion 12, which is part of the frame 10, is positioned closer to the end face 20c of the surface panel 20 (positioned more on the X1 side) than the tight-contact edge portion 14a is, as illustrated in Fig. 2. In the embodiment illustrated in Fig. 2, the cross-sectional shape of the inner end face 15 is a concave shape that is recessed toward the X1 side, that is, a concave curved line shape. When the inner end face 15 has this type of shape, it is possible to reduce thermal stress exerted on the tight-contact edge portion 14a, to prevent thermal stress from concentrating on the bonded portion of the tight-contact edge portion 14a, and to suppress damage to the decorative layer 22 in cooperation with the cushion function of the adhesion functional resin layer 23.

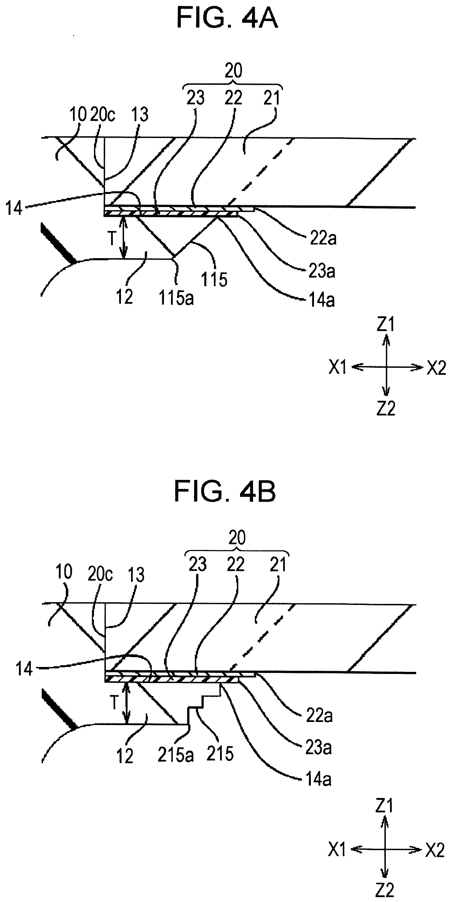

Figs. 4A and 4B illustrate variations of the inner end face 15 of the inner surface support portion 12. In the variation in Fig. 4A, the cross-sectional shape of an inner end face 115 is represented as a linearly inclined line so that an inner end edge portion 115a of the inner end face 115 is positioned more on the X1 side than the tight-contact edge portion 14a. In the variation in Fig. 4B, an inner end face 215 is in a stepped shape so that an inner end edge portion 215a of the inner end face 215 is positioned more on the X1 side than the tight-contact edge portion 14a. In the embodiment in Fig. 2 and the variations in Figs. 4A and 4B, the thickness dimension of the inner surface support portion 12 at the tight-contact edge portion 14a in the Z1-Z2 direction is smaller than the thickness dimension T of the inner surface support portion 12 in that direction. Therefore, thermal stress is likely to be eliminated when the inner end faces 15, 115, and 215 are deformed. This can mitigate the concentration of thermal stress on the tight-contact edge portion 14a.

The position, indicated by (b), of the resin edge portion 23a of the adhesion functional resin layer 23 matches the position, indicated by (a), of the decorative edge portion 22a of the decorative layer 22, or is more on the X1 side, that is, closer to the end face 20c than the position of the decorative edge portion 22a is. Therefore, when the surface panel 20 is viewed from the front side, the adhesion functional resin layer 23 is covered with the decorative layer 22. This can prevent the adhesion functional resin layer 23 from being directly viewed.

The frame 10 is formed from an elastomer having a tensile elastic modulus (longitudinal elastic modulus) of at least 100 MPa and at most 500 MPa, a tensile break strength of at least 5 MPa and at most 40 MPa, and a bending elastic modulus of at least 200 MPa and at most 1000 MPa. Therefore, thermal stress caused by a difference in coefficient of linear expansion between the frame 10 and the surface panel 20 is likely to be eliminated when the frame 10 itself is elastically deformed. This mitigates stress exerted on the surface panel 20 due to thermal stress, and also makes the surface panel 20 less likely to be distorted. Since the frame 10 is flexible, when the frame 10 is assembled as part of the vehicle-mounted display 1 or even when an external force is exerted on the frame 10 after it has been assembled, it is possible to restrain large stress from being exerted on the surface panel 20.

With the display device cabinet 2, the frame 10 bonded to the surface panel 20 is formed from an elastomer and the rear cover 30 linked to the back of the frame 10 is formed from a material that has a higher tensile elastic modulus and a higher bending elastic modulus and is more rigid when compared with the frame 10, as illustrated in Fig. 1. For example, the rear cover 30 is injection-molded by using an ABS resin or is die-cast by using a light metal material. The tensile elastic modulus and bending elastic modulus of the rear cover 30 are at least five times or preferably at least eight times those of the frame 10. Also, with the display device cabinet 2, the rear cover 30 has a larger surface area than the frame 10. Therefore, even when an elastomer is used to form the frame 10, the rigidity of the whole of the display device cabinet 2 can be maintained at a high level.

In the manufacturing method illustrated in Fig. 3, the first mold 40 lacks the step 43a in practice. Therefore, when the frame 10 is molded by an insert molding method, the boundary between the convex curved surface 43 and the interposing flat surface 41 of the first mold 40 abuts the inner surface of the adhesion functional resin layer 23, preventing this boundary from being brought into direct contact with the decorative layer 22. Therefore, pressure does not concentrate on part of the decorative layer 22 during mold clamping, and the decorative layer 22 is less likely to be damaged during molding.

The frame flat surface 18 with the width dimension W is formed on the outer surface of the frame 10 so that the frame flat surface 18 is flush with the outer surface 20a of the surface panel 20 and is contiguous to the decorative edge portion 22a, and the convex curved surface 16 is formed between the frame flat surface 18 and the side surface 17, as illustrated in Fig. 2. When the frame flat surface 18 with the width dimension W is formed, an edge portion 21b of the outer surface of the panel body 21 abuts the plane portion of the outer surface molding surface 52 of the second mold 50 in the clamped state illustrated in Fig. 3 but does not abut the curved surface portion of the outer surface molding surface 52, so the second mold 50 is not damaged by the edge portion 21b. This can also prevent the edge portion 21b of the panel body 21 from being damaged.

## Claims

1. A display device cabinet comprising:
a frame (10) having an opening (11) for display use; and
a surface panel (20) fixed to the opening (11)
the surface panel (20) having a panel body (21) formed from a transparent material, a decorative layer (22), which is colored, in tight contact with an inner surface (20b) of a circumferential area of the panel body (21), the inner surface (20b) facing an interior of the display device cabinet, and an adhesion functional resin layer (23) overlaid on an inner surface of the decorative layer (22),
the frame (10) is formed from a synthetic resin material cured while in a tight contact with the surface panel (20), the frame (10) having an end-face tight contact surface (13) in tight contact with an end face (20c) of the surface panel (20) and also having an inner-surface tight-contact surface (14) in tight contact with the inner surface (20b) of the circumferential area of the panel body (21), and
a tight-contact edge portion (14a) facing a center of the surface panel (20) is formed as part of the inner-surface tight-contact surface (14) so that the tight-contact edge portion (14a) is at a position at which the tight-contact edge portion (14a) overlaps both the decorative layer (22) and the adhesion functional resin layer (23).

2. The display device cabinet according to Claim 1, wherein a resin edge portion (23a) of the adhesion functional resin layer (23), the resin edge portion (23a) facing the center of the surface panel (20), is at the same position as a decorative edge portion (22a) of the decorative layer (22), the decorative edge portion (22a) facing the center of the surface panel (20), or at a position closer to the end face (20c) than the decorative edge portion (22a) is; and the tight-contact edge portion (14a) is at the same position as the resin edge portion (23a) or at a position closer to the end face (20c) than the resin edge portion (23a) is.

3. The display device cabinet according to Claim 1 or 2, wherein
an inner surface support portion (12) facing the interior of the display device cabinet is formed as part of the frame (10), and the inner surface (20b) support portion has the inner-surface tight-contact surface (14) and an inner end face (15) facing the center of the surface panel (20); and
an inner end edge portion (15a) of the inner end face (15), the inner end edge portion (15a) facing the interior of the display device cabinet, is at a position closer to the end face (20c) than the tight-contact edge portion (14a) is.

4. The display device cabinet according to Claim 3, wherein a concave surface contiguous to the tight-contact edge portion (14a) is formed as part of the inner end face (15) .

5. The display device cabinet according to one of Claims 1 - 4, whereinthe frame (10) is formed from an elastomer having a tensile elastic modulus of at least 100 MPa and at most 500 MPa.

6. The display device cabinet according to one of Claims 1 - 5, whereinthe frame (10) is formed from an elastomer having a bending elastic modulus of at least 200 MPa and at most 1000 MPa.

7. The display device cabinet according to Claim 5 or 6, wherein a rear cover (30) is linked to the frame (10) to form the display device cabinet; the rear cover (30) has a larger tensile elastic modulus and a larger bending elastic modulus than the frame (10); and the rear cover (30) has a larger surface area than the frame (10).

8. A method of manufacturing a display device cabinet that has a frame (10) having an opening (11) for display use and also has a surface panel (20) fixed to the opening (11), the method comprising:
using a surface panel (20) that has a panel body (21) formed from a transparent material, a decorative layer (22), which is colored, in tight contact with an inner surface (20b) of a circumferential area of the panel body (21), the inner surface (20b) facing an interior of the display device cabinet, and an adhesion functional resin layer (23) overlaid on an inner surface of the decorative layer (22);
molding the frame (10) from a synthetic resin material with the surface panel (20) fixed in a mold so that the frame (10) has an end-face tight contact surface (13) in tight contact with an end face (20c) of the surface panel (20) and also has an inner-surface tight-contact surface (14) in tight contact with the inner surface (20b) of the circumferential area of the panel body (21); and
forming a tight-contact edge portion (14a), which faces a center of the surface panel (20), as part of the inner-surface tight-contact surface (14) so that the a tight-contact edge portion (14a) is at a position at which the tight-contact edge portion (14a) overlaps both the decorative layer (22) and the adhesion functional resin layer (23).

9. The method of manufacturing a display device cabinet according to Claim 8, further comprising forming a resin edge portion (23a), which faces the center of the surface panel (20), as part of the adhesion functional resin layer (23) so that the resin edge portion (23a) is at the same position as a decorative edge portion (22a) of the decorative layer (22), the decorative edge portion (22a) facing the center of the surface panel (20), or at a position closer to the end face (20c) than the decorative edge portion (22a) is, the method **characterized in that** the tight-contact edge portion (14a) is formed at the same position as the resin edge portion (23a) or at a position closer to the end face (20c) than the resin edge portion (23a) is.

10. The method of manufacturing a display device cabinet according to Claim 8 or 9, further comprising:
forming an inner surface support portion (12), which faces the interior of the display device cabinet, as part of the frame (10), the inner surface support portion (12) having the inner-surface tight-contact surface (14) and an inner end face (15) facing the center of the surface panel (20); and
forming an inner end edge portion (15a), which faces the interior of the display device cabinet, as part of the inner end face (15) so that the inner end edge portion (15a) is at a position closer to the end face (20c) than the tight-contact edge portion (14a) is.

11. The method of manufacturing a display device cabinet according to Claim 10, the method further comprising forming a concave surface, which is contiguous to the tight-contact edge portion (14a), as part of the inner end face (15) .
